# EUROPEAN PATENT SPECIFICATION

(11) **EP 2 383 354 B1**
(45) Date of publication and mention of the grant of the patent: **07.03.2018**
(21) Application number: 10735697.4
(22) Date of filing: 13.01.2010
(51) Int. Cl.: C22B 59/00, C22B 9/02, C22B 9/04, C22B 9/14, C22C 28/00, C23C 14/34, C22B 5/04, C22B 5/16

(54) **METHOD FOR MANUFACTURING HIGH-PURITY ERBIUM, HIGH-PURITY ERBIUM, SPUTTERING TARGET COMPOSED OF HIGH-PURITY ERBIUM**
VERFAHREN ZUR HERSTELLUNG VON HOCHREINEM ERBIUM, HOCHREINES ERBIUM, SPUTTERING-TARGET AUS DEM HOCHREINEN ERBIUM
PROCÉDÉ DE FABRICATION D'ERBIUM DE HAUTE PURETÉ, ERBIUM DE HAUTE PURETÉ, CIBLE DE PULVÉRISATION COMPOSÉE D'ERBIUM DE HAUTE PURETÉ

(30) Priority: 29.01.2009 JP 2009017629
(43) Date of publication of application: 02.11.2011
(73) Proprietor: JX Nippon Mining & Metals Corporation, Tokyo 100-8164 (JP)
(72) Inventor: SHINDO, Yuichiro, Kitaibaraki-shi Ibaraki 319-1535 (JP); YAGI, Kazuto, Kitaibaraki-shi Ibaraki 319-1535 (JP)
(74) Representative: Hoarton, Lloyd Douglas Charles
(86) International application number: PCT/JP2010/050258
(87) International publication number: WO 2010/087227

(56) References cited:
- JP-A- 2009 001 866
- JP-A- 2009 001 866
- MILLER A E ET AL: "Preparation of a new type of nonstoichiometric rare earth oxide", JOURNAL OF INORGANIC AND NUCLEAR CHEMISTRY, PERGAMON PRESS, GB, vol. 27, no. 9, 1 September 1965 (1965-09-01), pages 1955-1960, XP008151403, ISSN: 0022-1902, DOI: 10.1016/0022-1902(65)80050-1 [retrieved on 2003-05-16]

## Description

### TECHNICAL FIELD

The present invention relates to a method of highly purifying erbium, which has a high vapor pressure and is difficult to be refined in a molten metal state, high-purity erbium obtained thereby, a sputtering target composed of high-purity erbium, and a metal gate film having high-purity erbium as a main component.

### BACKGROUND ART

Erbium (Er) is a rare-earth element, and it is contained in the earth's crust as a mineral source and as a mixed composite oxide. Although rare-earth elements are so called because they are separated from relatively rare existing minerals, they are not that rare when viewed in light of the entire crust. Erbium's atomic number is 68, and it is a gray-colored metal having an atomic weight of 167.3 and comprising a hexagonal close-packed structure. Erbium has a melting point of 1530°C, a boiling point of 2860°C, and a density of 9.07 g/cm³. Erbium's surface is oxidized in the air, it gradually melts in water, and it is soluble in acid. Erbium has superior corrosion resistance and wear resistance properties, shows high paramagnetic property, and generates oxides (Er₂O₃) at high temperatures.

With rare-earth elements, it is generally said that compounds with the oxidation number 3 are stable, and erbium is also trivalent. In recent years, research and development are being promoted for using erbium as a metal gate material or an electronic material for High-k use and the like, and is a metal that is attracting attention.

Nevertheless, since erbium metal has a problem in that it is easily oxidized during refining, a high-purity erbium product did not exist since its high purification was difficult.

Moreover, erbium has been used as a magnetic refrigerant material, but since its use as an electronic component was not considered, it cannot be said that it was a metal that attracted much attention. Accordingly, there are not many documents relating to practical methods of extracting erbium. Some reference documents are listed below, but they merely describe erbium as one of the elements in the extraction of rare-earth metals.

Disclosed is technology of manufacturing rare-earth elements of Sm, Eu and Yb by mixing the oxide powders of Sm, Eu and Yb and the misch metal, making the mixed powder into a briquette, and subjecting it to vacuum thermal reduction using the misch metal as the reductant. The misch metal is previously subject to hydrogenation treatment to obtain powdery misch metal hydride, and this is mixed and molded into a briquette in order to prevent the oxidization and combustion during the pulverization process of the misch metal (for example, refer to Patent Document 1). In this example, although there is a scheme in the use of misch metal as the reductant, it does not aim for higher purification, and there is a problem in that there is a limit in achieving high purification.

Proposed is technology in which halide of the rare-earth metal is reduced with calcium or calcium hydride; and when the obtained rare-earth metal and the slag are divided, a slag separating jig is placed in molten slag to solidify the slag and remove the slag together with the jig. Lanthanum, cerium, praseodymium, and neodymium are selected as the rare earths (for example, refer to Patent Document 2). Since this technology is unable to sufficiently eliminate the slag, there is a problem in that it is difficult to achieve high purification.

Proposed is a manufacturing method of rare-earth metals by adding a reductant to a fluoride material of rare-earth metal and performing thermal reduction of heating the mixture at high temperature. A mixed composition comprising fluorides of rare-earth metals and lithium fluoride, or a mixed composition added with one or more types of barium fluoride and calcium fluoride is used as the raw material. In this case, the use of a fused-salt electrolysis bath is proposed, and disclosed is that the oxygen content will become 1000 ppm thereby (for example, refer to Patent Document 3). This technology is based on the use of a fused-salt electrolysis bath, and there is a problem in that a complicated process is required and the effect of oxygen elimination is also insufficient. There is also the problem of lithium, barium, calcium and so on being included as impurities.

Proposed is technology of mixing a mixed composition of fluoride of rare-earth metal and lithium fluoride or a mixed composition added with one or more types of barium fluoride and calcium fluoride, and rare-earth metals; and subjecting the mixture to fusion to extract rare earths. Thermally reduced commercial rare earths are used as the rare earths, and for the mixed composition, a fused-salt electrolysis solvent bath for manufacturing alloy of rare-earth metals and iron group transition metals is used.

Although it is also possible to obtain high-purity rare-earth metals in which the oxygen content is 300 ppm or less, and with few impurities such as calcium, lithium and fluorine (for example, refer to Patent Document 4), this technology is also based on the use of a fused-salt electrolysis bath and requires a complicated process. In addition, there is the problem of lithium, barium, calcium and so on being included as impurities, and effect of oxygen elimination is also insufficient.

Proposed is a refining method for obtaining high-purity rare earths by adding Mg or Zn to rare-earth metals containing Ta as impurities, melting the mixture in a crucible, solidifying this, eliminating the portion highly containing Ta located at the bottom of the crucible, and performing vacuum distillation to the portion low containing Ta (for example, refer to Patent Document 5). Nevertheless, since there is a problem in that the added metal are included as impurities and the elimination of Ta is also insufficient, there is a problem in that the level of high purification is low.

As shown in the foregoing documents, the effect of refining erbium is not necessarily sufficient, and in particular only a handful of documents seek the reduction of oxygen. Among those that do, there is a problem in that the reduction of oxygen is insufficient. In addition, methods that adopt the fused-salt electrolysis entail a complicated process, and there is a problem in that the refining effect is insufficient. Like this, the current situation is that there is no efficient and stable manufacturing method to obtain high-purity erbium that is a high-melting point metal, has a high vapor pressure, and in which refining is difficult in a molten metal state.

[Patent Document 1] Japanese Laid-Open Patent Publication No. S61-9533
[Patent Document 2] Japanese Laid-Open Patent Publication No. S63-11628
[Patent Document 3] Japanese Laid-Open Patent Publication No. H7-90410
[Patent Document 4] Published Japanese Translation No. H7-90411 of PCT Application
[Patent Document 5] Japanese Laid-Open Patent Publication No. H8-85833

### SUMMARY OF INVENTION

### [Problems to be Solved by the Invention]

An object of this invention as defined in the claims is to provide a method of highly purifying erbium, which has a high melting point and is difficult to be refined in a molten metal state, as well as technology for efficiently and stably providing high-purity erbium obtained with the foregoing method, a sputtering target composed of high-purity erbium, and a metal gate film having high-purity erbium as a main component.

### [Means for Solving the Problems]

As a result of intense study conducted by the present inventors in order to achieve the foregoing object; provided is a manufacturing method of high-purity erbium, wherein crude erbium oxide is mixed with reducing metal, erbium is reduced and distilled to refine the erbium by heating the mixture in a vacuum, and the distillate is melted in an inert atmosphere to obtain high-purity erbium. This manufacturing process is the foundation of the present invention, and, with respect to the respective conditions thereof, the optical conditions may be suitably selected according to the purity of the raw material and the type of reducing metal to be used.

Generally speaking, when mixing erbium oxide and reducing metal and heating the mixture to perform the reduction and distillation of erbium, it is desirable to heat the mixture to a temperature of 1500 to 2500°C in order to efficiently perform the reduction and distillation. Normally, a raw material having a purity of 3N or less is used, but high-purity erbium having a purity of 4N can be obtained based on the refining in the manufacturing method of high-purity erbium according to the present invention.

As described in the foregoing conventional technologies, erbium easily bonds with oxygen, and is a material in which oxygen elimination is difficult. Nevertheless, the present disclosure is able to obtain high-purity erbium, wherein the purity excluding rare-earth elements and gas components is 4N or higher and the oxygen content is 200 wtppm or less. The foregoing high-purity erbium is a novel material, and is covered by the present disclosure.

In addition, by the manufacturing method of high-purity erbium according to the present disclosure; it is possible to achieve that the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less.

The manufacturing method of high-purity erbium according to the present disclosure covers the foregoing method. In addition, the high-purity erbium obtained as described above is a novel material, and is covered by the present disclosure.

The erbium obtained by the foregoing distillation is melted in a vacuum and solidified into an ingot. This ingot can be cut into a prescribed size and subject to a grinding process in order to form a sputtering target.

Accordingly, it is possible to obtain a high-purity erbium sputtering target, wherein the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less.

In addition, by sputtering the foregoing target, it is possible to form on a substrate a metal gate film having high-purity erbium as a main component, wherein the purity excluding rare-earth elements and gas components is 4N or higher, oxygen content is 200 wtppm or less, elements of alkali metals are respectively 10 wtppm or less, elements of transition metals are respectively 10 wtppm or less, and radioactive elements are respectively 10 wtppb or less. The foregoing sputtering target and metal gate film are also novel materials, and are covered by the present disclosure.

### EFFECTS OF INVENTION

The present invention as defined in the claims yields superior effects of being able to provide a method of highly purifying erbium, which has a high vapor pressure and is difficult to be refined in a molten metal state, as well as efficiently and stably providing high-purity erbium obtained thereby, a sputtering target composed of high-purity erbium, and a metal gate film having high-purity erbium as a main component.

### DESCRIPTION OF EMBODIMENTS

The present invention as defined in the claims is able to use a raw material of crude erbium oxide having a purity level of 3N or lower as the erbium raw material for high purification. This raw material contains Na, K, Ca, Mg, Fe, Cr, Ni, O, C, N and so on as primary impurities excluding rare-earth elements.

The crude erbium oxide is mixed with metal with reducing character and thermally reduced in a vacuum at 1500 to 2500°C. Although yttrium (Y) metal having low vapor pressure and high reducing power is effective as the metal with reducing character, lanthanum (La) and other reducing metals may also be used. There is no particular limitation on the type of reducing metal so as long as it has low vapor pressure and high reducing power.

Pursuant to the progress of reduction of erbium oxide, erbium is distilled and erbium with improved purity is stored in the capacitor. This distillate is melted in a crucible, and solidified into an ingot. The melting and solidification process is preferably performed in an inert atmosphere. It is thereby possible to suppress the rise in oxygen content. Although it is also possible to perform the melting and solidification process in a vacuum, since the yield tends to become inferior, it is desirable to perform the process in an inert atmosphere as described above. Nevertheless, the present invention is not denying the performance of the foregoing process in a vacuum.

It is thereby possible to manufacture high-purity erbium, wherein the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less.

The foregoing alkali metal elements are lithium, sodium, potassium, rubidium, cesium, and francium, and these elements are electrically positive. For example, if erbium is used for an electronic component, there is a problem in that the elements with a small atomic radius will easily move within the device, and destabilize the properties of the device. As the total amount, inclusion up to 50 wtppm, and preferably up to 10 wtppm is acceptable, but it goes without saying that less the better. Thus, content of the respective alkali metal elements is 10 wtppm or less, and preferably 1 wtppm or less.

Moreover, the same problems arise with alkaline-earth metal elements, and the content of the respective alkaline-earth metal elements is 20 wtppm or less, and preferably 1 wtppm or less.

The foregoing transition metal elements are metals that belong to groups 3 to 11 in the periodic table, and representative examples thereof are titanium, vanadium, chromium, manganese, iron, cobalt, nickel, copper, zinc, and the like. These elements induce the increase of the leak current and cause the deterioration in pressure resistance. As the total amount, inclusion up to 1000 wtppm, and preferably up to 500 wtppm is acceptable, but less the better. As described above, since the transition metal elements are individually analyzed and controlled, the amount of inclusion thereof is desirably reduced to 100 wtppm or less, more preferably to 10 wtppm or less, and most preferably to 1 wtppm or less, respectively.

Representative examples of radioactive elements are uranium, actinium, thorium, lead, and bismuth, and the radioactive elements cause a soft error of the accumulated charge in the memory cells becoming inverted. Accordingly, it is necessary to reduce the amounts of such radioactive elements as well as limit the alpha dose that is generated from such elements. As the total amount of radioactive elements, the inclusion up to 20 wtppb is acceptable, but should be reduced as much as possible. As described above, each of the foregoing elements can be individually analyzed and controlled, and, preferably, these elements are respectively 10 wtppb or less, and more preferably 5 wtppb or less.

As a result of measuring the alpha dose of the target of the present invention with a gas-flow proportional counter as the measuring device, the alpha dose was 0.01 cph/cm² or less.

The reason why the rare-earth elements are excluded from the high-purity erbium as described above is because: it is technically difficult to eliminate such rare-earth elements upon manufacturing high-purity erbium since the other rare earths themselves have similar chemical properties as erbium; and the properties will not be affected significantly since their properties are approximate even if they are included as impurities.

Under the foregoing circumstances, the inclusion of other rare earths is tolerated to a certain degree, but it goes without saying that the inclusion of such other rare earths is reduced as much as possible in order to improve the properties of the erbium itself.

Moreover, the reason why the purity excluding gas components is 4N or higher is because the elimination of gas components is difficult, and, if such gas components are counted, it will no longer be an indication of the improvement of purity. In addition, it is often the case that the existence of small amounts of gas components is harmless in comparison to other impurity elements.

Nevertheless, even in the foregoing cases, in particular, oxygen among the gas components is easily incorporated. In cases where the oxygen inclusion exceeds 200 wtppm, if oxygen is incorporated into the target described later, splashes will occur during the sputtering due to the oxygen, and uniform deposition cannot be performed.

In addition, the existence of oxides is undesirable since it will cause the generation of particles and nodules. Moreover, since it will have no small effect on the properties of the metal gate film described later, it goes without saying that it is necessary to reduce oxides as much as possible. Accordingly, it is desirable to strictly control the oxygen content as a matter of course. In the present invention, the oxygen content is 10 wtppm or less.

When forming a thin film of an electronic material such as a gate insulation film or a thin film for metal gate, such thin film is often formed by sputtering, and sputtering is a superior method as a means for forming a thin film. Accordingly, it is effective to use the foregoing erbium ingot to manufacture a high-purity erbium sputtering target.

The target can be manufactured with standard processes such as forging, rolling, machining, and finishing (polishing). In particular, there is no particular limitation in the manufacturing process, and the manufacturing process may be arbitrarily selected.

Based on the above, the present disclosure provides a high-purity erbium sputtering target characterized in that the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less. Upon manufacturing the target, the foregoing high-purity erbium ingot is cut into a prescribed size, and this is machined and polished.

Moreover, by sputtering this high-purity target, high-purity erbium can be deposited on a substrate. It is thereby possible to form on a substrate a metal gate film having high-purity erbium as a main component characterized in that the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less. The composition of the target is reflected in the film on the substrate, and a high-purity erbium film can thereby be formed.

Although the metal gate film may sustain the uniform composition with the foregoing high-purity erbium, it may also be formed as mixture, alloy or compound with other gate materials. This can be achieved by the simultaneous sputtering with the target of other gate materials or sputtering using a mosaic target. The present invention also covers the foregoing aspects. Although the impurity content will change depending on the impurity content in the raw material, the respective impurities can be adjusted to be within the foregoing range by adopting the method described above.

The present invention provides a method of highly purifying erbium; and technology capable of efficiently and stably providing high-purity erbium based on the foregoing method, a sputtering target composed of high-purity material erbium, and a thin film for metal gate having high-purity erbium as main component.

### [Examples]

The present invention is now explained in detail with reference to the Examples. These Examples are merely illustrative, and the present invention shall in no way be limited thereby. In other words, various modifications and other embodiments based on the technical spirit claimed in the claims shall be included in the present invention as a matter of course.

### (Comparative Example 1)

As the erbium raw material, crude erbium oxide (Er₂O₃) of 3N was used. The impurities contained in this raw material are shown in Table 1.

Subsequently, the erbium raw material was mixed with yttrium (Y) as the reducing metal, and a vacuum distillation apparatus was used to thermally reduce the mixture in a vacuum at 1600°C. Pursuant to the progress of reduction of erbium oxide, erbium was distilled to improve the purity, and the erbium with improved purity was stored in a capacitor.

Distillation and thermal reduction reaction was as follows:

Er₂O₃ (solid) + 2Y (solid) → 2Er (gas) + 3Y₂O₃ (solid)

10 kg of erbium was extracted from the erbium distillate stored in the capacitor, a CaO crucible was used to melt the extracted erbium in Ar atmosphere, and this was solidified into an ingot.

It was thereby possible to manufacture high-purity erbium in which the purity excluding rare-earth elements and gas components is 4N or higher, oxygen content is 40 wtppm or less, elements of alkali metals are respectively 1 wtppm or less, elements of transition metals are respectively 20 wtppm or less, and radioactive elements are respectively 5 wtppb or less. The results are also shown in Table 1.

As a result of measuring the alpha dose of the target with a gas-flow proportional counter as the measuring device, the alpha dose was 0.01 cph/cm² or less.

The sputtering target obtained from the foregoing ingot was also able to retain a high purity level, and it was possible to form a high-purity erbium thin film with uniform characteristics on a substrate by sputtering the foregoing sputtering target.

**[Table 1]**

| | Alkali metals | | Alkaline-earth metals | | Transition metals | | | Gas components | | | Radioactive elements | |
|---|---|---|---|---|---|---|---|---|---|---|---|---|
| Elements | Na | K | Ca | Mg | Fe | Cr | Ni | O | C | N | U | Th |
| Raw material | 150 | 20 | 120 | 80 | 1600 | 100 | 300 | - | 1000 | 1wt% | 1000 | 5000 |
| Example 1 | 0.2 | <0.1 | 0.5 | 0.8 | 16 | 6.5 | 0.5 | 40 | 20 | <10 | <5 | <5 |
| Example 2 | 0.6 | 0.3 | <0.1 | 0.7 | 7 | 1.4 | 0.7 | 60 | 70 | 20 | 6 | 8 |
| Example 3 | 10 | 1.0 | 13 | 4.5 | 100 | 20 | 30 | 200 | 50 | 60 | <5 | <5 |
| Example 4 | <0.1 | <0.1 | <0.1 | <0.1 | 0.3 | 0.1 | 0.1 | <10 | <10 | <10 | <5 | <5 |
| Example 5 | 3.5 | 0.7 | 6 | 2 | 43 | 13 | 21 | 120 | 30 | 20 | <5 | <5 |

| | | | | | | | | | | | | |
|---|---|---|---|---|---|---|---|---|---|---|---|---|
| (Excluding the indication "wt%" for the raw material, unit of others is wtppm; provided that the unit is wtppb for U and Th) | | | | | | | | | | | | |

### (Comparative Example 2)

The same raw material as Example 1 was used to perform reduction. The entire process was performed as with Example 1 other than that La was used as the reductant.

It was thereby possible to manufacture high-purity erbium in which the purity excluding rare-earth elements and gas components is 4N or higher, oxygen content is 60 wtppm or less, elements of alkali metals are respectively 1 wtppm or less, elements of transition metals are respectively 10 wtppm or less, and radioactive elements are respectively 10 wtppb or less. Although both Example 1 and Example 2 were able to achieve an oxygen content of 100 wtppm or less, in the case of Example 2, the content of radioactive elements U and Th was slightly high.

The sputtering target obtained from the foregoing ingot was also able to retain a high purity level, and it was possible to form a high-purity erbium thin film with uniform characteristics on a substrate by sputtering the foregoing sputtering target. The results are also shown in Table 1.

### (Comparative Example 3)

The entire process was performed as with Example 1 other than that erbium oxide of 3N level was used as the raw material and the reduction/distillation temperature was set to 2500°C.

It was thereby possible to manufacture high-purity erbium in which the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 5 wtppb or less. In this Example, the impurity content was high overall since the reduction/distillation temperature was high, but it was still possible to keep it within an acceptable range.

The sputtering target obtained from the foregoing ingot was also able to retain a high purity level, and it was possible to form a high-purity erbium thin film with uniform characteristics on a substrate by sputtering the foregoing sputtering target. The results are also shown in Table 1.

### (Invention Example 4)

The metal erbium obtained in Example 1 was subject to distillation once again to manufacture metal erbium. The impurity content thereof is shown in Table 1.

It was thereby possible to manufacture high-purity erbium in which the purity excluding rare-earth elements and gas components is 4N or higher, oxygen content is 10 wtppm or less, elements of alkali metals are respectively 1 wtppm or less, elements of transition metals are respectively 1 wtppm or less, and radioactive elements are respectively 5 wtppb or less. In this Example, results of an extremely low impurity concentration were obtained due to the effect of redistillation.

The sputtering target obtained from the foregoing ingot was also able to retain an even higher purity level as shown in Table 1, and it was possible to form a high-purity erbium thin film with uniform characteristics on a substrate by sputtering the foregoing sputtering target.

### (Comparative Example 5)

The entire process was performed as with Example 1 other than that erbium oxide of 3N level was used as the raw material and the reduction/distillation temperature was set to 2000°C.

It was thereby possible to manufacture high-purity erbium in which the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 5 wtppb or less. In this Example, the impurity content was of medium level between Example 1 and Example 3 since the reduction/distillation temperature was set in the middle of those Examples.

The sputtering target obtained from the foregoing ingot was also able to retain a high purity level, and it was possible to form a high-purity erbium thin film with uniform characteristics on a substrate by sputtering the foregoing sputtering target. The results are also shown in Table 1.

### (Comparative Example 6)

The same raw material as Example 1 was used and Ca was used as the reductant, but it was not possible to perform the reduction. This is because Ca was unable to function as a reductant.

### (Comprehensive Evaluation of Results of Examples)

Although not specifically illustrated in the foregoing Examples, it was confirmed that the intended results can be obtained if the temperature upon performing the reduction and distillation of erbium is within the range of 1500 to 2500°C.

Moreover, although not specifically illustrated in the Examples, when a high-purity raw material having a purity exceeding 3N was used, it was confirmed that high-purity erbium having a purity of 4N, wherein the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less, could be obtained under the refining conditions of the present invention. It was particularly confirmed that oxygen content of 200 wtppm or less can be achieved

The foregoing high-purity erbium is able to sustain its purity even when processed into a target; and a high-purity erbium sputtering target, in which the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less, was obtained.

In addition, even when the foregoing high-purity erbium was deposited on a substrate by sputtering, the purity of the target was reflected in the film, and it was confirmed that metal gate film having high-purity erbium as a main component, wherein the purity excluding rare-earth elements and gas components is 4N or higher, oxygen content is 200 wtppm or less, elements of alkali metals are respectively 10 wtppm or less, elements of transition metals are respectively 100 wtppm or less, and radioactive elements are respectively 10 wtppb or less, can be obtained.

The foregoing is not indicated in the Examples in order to avoid repetition and complication, but was confirmed as specific conditions.

### INDUSTRIAL APPLICABILITY

The manufacturing method of high-purity erbium according to the present invention can resolve the problems encountered in conventional methods; namely, that erbium has a high melting point and vapor pressure and is difficult to be refined in a molten metal state; and facilitates the high purification of erbium. The present invention yields superior effects in being able to provide the specific method thereof, as well as technology for efficiently and stably providing high-purity erbium obtained with the foregoing method, a sputtering target composed of high-purity erbium, and a metal gate film having high-purity erbium as a main component. In particular, the present invention is useful as materials of a gate insulation film or a thin film for metal gate since they will not, as electronic materials to be disposed in the vicinity of the silicon substrate, deteriorate or disturb the functions of electronic devices.

## Claims

1. A method of manufacturing high-purity erbium comprising:
mixing crude erbium oxide having a purity of 3N or less with reducing metal,
heating the mixture in a vacuum to distilland reduce the erbium,
repeating distillation, and
melting the distillate in an inert atmosphere to obtain high-purity erbium, wherein the purity excluding rare-earth elements and gas components is 4N or higher, oxygen content is 10 wtppm or less, elements of alkali metals are respectively 1 wtppm or less, elements of transition metals are respectively 1 wtppm or less, and radioactive elements are respectively 5 wtppm or less.

2. The method of claim 1, wherein the mixture is heated to a temperature of 1500 to 2500°C during the reduction and distillation of erbium.

3. The method of claim 1 further comprising melting the distillate to obtain the high-purity erbium as an ingot and machining the ingot to produce a high purity sputtering target.

4. High-purity erbium, wherein the purity excluding rare-earth elements and gas components is 4N or higher and the oxygen content is 10 wtppm or less, elements of alkali metals are respectively 1 wtppm or less, elements of transition metals are respectively 1 wtppm or less, and radioactive elements are respectively 5 wtppm or less.

5. A high-purity erbium sputtering target, wherein the purity excluding rare-earth elements and gas components is 4N or higher, oxygen content is 10 wtppm or less, elements of alkali metals are respectively 1 wtppm or less, elements of transition metals are respectively 1 wtppm or less, and radioactive elements are respectively 5 wtppb or less.

## Patentansprüche

1. Verfahren zur Herstellung von hochreinem Erbium, umfassend:
Mischen von rohem Erbiumoxid, das eine Reinheit von 3N oder weniger aufweist, mit reduzierendem Metall,
Erhitzen des Gemischs in einem Vakuum, um das Erbium zu destillieren und zu reduzieren,
Wiederholen der Destillation und
Schmelzen des Destillats in einer inerten Atmosphäre, um hochreines Erbium zu erhalten, wobei die Reinheit ausschließlich Seltenerdelemente und Gasbestandteile 4N oder höher ist, der Sauerstoffgehalt 10 Gew.-ppm oder weniger ist, Elemente der Alkalimetalle jeweils 1 Gew.-ppm oder weniger sind, Elemente der Übergangsmetalle jeweils 1 Gew.-ppm oder weniger sind und radioaktive Elemente jeweils 5 Gew.-ppm oder weniger sind.

2. Verfahren nach Anspruch 1, wobei das Gemisch während der Reduktion und Destillation von Erbium auf eine Temperatur von 1500 bis 2500 °C erhitzt wird.

3. Verfahren nach Anspruch 1, ferner umfassend das Schmelzen des Destillats, um das hochreine Erbium als Ingot zu erhalten, und Bearbeiten des Ingots, um ein hochreines Sputtering-Target zu produzieren.

4. Hochreines Erbium, wobei die Reinheit ausschließlich Seltenerdelemente und Gasbestandteile 4N oder höher ist und der Sauerstoffgehalt 10 Gew.-ppm oder weniger ist, Elemente der Alkalimetalle jeweils 1 Gew.-ppm oder weniger sind, Elemente der Übergangsmetalle jeweils 1 Gew.-ppm oder weniger sind und radioaktive Elemente jeweils 5 Gew.-ppm oder weniger sind.

5. Hochreines Erbium-Sputtering-Target, wobei die Reinheit ausschließlich Seltenerdelemente und Gasbestandteile 4N oder höher ist, der Sauerstoffgehalt 10 Gew.-ppm oder weniger ist, Elemente der Alkalimetalle jeweils 1 Gew.-ppm oder weniger sind, Elemente der Übergangsmetalle jeweils 1 Gew.-ppm oder weniger sind und radioaktive Elemente jeweils 5 Gew.-ppb oder weniger sind.

## Revendications

1. Un procédé de fabrication d'un erbium de haute pureté consistant à :
mélanger un oxyde d'erbium brut ayant une pureté égale ou inférieure à 3N avec un métal réducteur,
chauffer le mélange dans un vide pour distiller et réduire l'erbium,
répéter la distillation, et
faire fondre le distillat dans une atmosphère inerte pour obtenir de l'erbium de haute pureté, dans lequel la pureté, à l'exclusion d'éléments de terres rares et de composants gazeux, est égale ou supérieure à 4N, la teneur en oxygène est égale ou inférieure à 10 ppm en poids, des éléments de métaux alcalins sont respectivement égaux ou inférieurs à 1 ppm en poids, des éléments de métaux de transition sont respectivement égaux ou inférieurs à 1 ppm en poids et des éléments radioactifs sont respectivement égaux ou inférieurs à 5 ppm en poids.

2. Le procédé selon la revendication 1, dans lequel le mélange est chauffé à une température comprise entre 1500 et 2500°C durant la réduction et la distillation de l'erbium.

3. Le procédé selon la revendication 1 consistant en outre à faire fondre le distillat pour obtenir l'erbium de haute pureté sous forme de lingot et à usiner le lingot pour produire une cible de pulvérisation de haute pureté.

4. Un erbium de haute pureté, dans lequel la pureté à l'exclusion d'éléments de terres rares et de composants gazeux est égale ou supérieure à 4N et la teneur en oxygène est égale ou inférieure à 10 ppm en poids, des éléments de métaux alcalins sont respectivement égaux ou inférieurs à 1 ppm en poids, des éléments de métaux de transition sont respectivement égaux ou inférieurs à 1 ppm en poids et des éléments radioactifs sont respectivement égaux ou inférieurs à 5 ppm en poids.

5. Une cible de pulvérisation d'erbium de haute pureté, dans lequel la pureté à l'exclusion d'éléments de terres rares et de composants gazeux est égale ou supérieure à 4N et la teneur en oxygène est égale ou inférieure à 10 ppm en poids, des éléments de métaux alcalins sont respectivement égaux ou inférieurs à 1 ppm en poids, des éléments de métaux de transition sont respectivement égaux ou inférieurs à 1 ppm en poids et des éléments radioactifs sont respectivement égaux ou inférieurs à 5 ppm en poids.
